# EUROPEAN PATENT SPECIFICATION

(11) **EP 4 618 716 B1**
(45) Date of publication and mention of the grant of the patent: **29.07.2026**
(21) Application number: 25151727.2
(22) Date of filing: 14.01.2025
(51) Int. Cl.: H10D 30/66, H10D 62/10, H10D 62/17

(54) **POWER SEMICONDUCTOR DEVICE**
LEISTUNGSHALBLEITERANORDNUNG
DISPOSITIF SEMI-CONDUCTEUR DE PUISSANCE

(30) Priority: 15.03.2024 KR 20240036738
(43) Date of publication of application: 17.09.2025
(73) Proprietor: Hyundai Mobis Co., Ltd., Gangnam-gu Seoul 06141 (KR)
(72) Inventor: LEE, Ju Hwan, 16891 Yongin-si (KR); WOO, Hyuk, 16891 Yongin-si (KR); KANG, Min Gi, 16891 Yongin-si (KR); HA, Jeong Mok, 16891 Yongin-si (KR); HWANG, Jun Ha, 16891 Yongin-si (KR); KIM, Tae Yang, 16891 Yongin-si (KR); KIM, Sin A, 16891 Yongin-si (KR)
(74) Representative: Vossius & Partner Patentanwälte Rechtsanwälte mbB

(56) References cited:
- US-A1- 2017 141 223
- US-A1- 2022 157 987
- US-A1- 2023 387 194
- US-B2- 10 367 091

## Description

### CROSS-REFERENCE TO RELATED APPLICATION

This application claims the benefit of Korean Patent Application No. 10-2024-0036738, filed in the Korean Intellectual Property Office on March 15, 2024.

### 1. Field

The present disclosure relates to a power semiconductor device and, more particularly, to a power semiconductor device including a plurality of doped regions.

### 2. Description of the Related Art

A power semiconductor device is a semiconductor device that operates in a high-voltage and high-current environment. The power semiconductor device may be used in a field requiring high power switching, such as an inverter. Examples of transistors that may be used as the power semiconductor device include an insulated gate bipolar transistor (IGBT) and a power metal-oxide semiconductor field effect transistor (MOSFET), etc.

The power semiconductor device may include a gate, and the gate may include an insulating layer. To maintain the stability of a trench-shaped gate of the power semiconductor device including the gate, a predetermined doped region may be formed within a semiconductor substrate.

US 2023/387194 A1 discloses a field effect transistor and method of manufacturing the same.

US 10 367 091 B2 discloses a trench gate semiconductor switching element.

US 2017/141223 A1 discloses a silicon carbide semiconductor substrate wherein trenches and n+ high impurity concentration regions are formed in a first principal surface side thereof.

US 2022/157987 A1 discloses a vertical power MOSFET comprising first and second trench gate electrode layers in respective trenches recessed into a semiconductor substrate and comprising a planar gate electrode layer configured to contact an upper surface of each of the first and second trench gate electrode layers.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter. The present invention is defined by independent claim 1; the dependent claims describe embodiments of the present invention.

In a general aspect, here is provided a power semiconductor device as defined in claim 1.

The power semiconductor device may include a field junction region configured to contact the lower surface of the first body region and the outwardly convex boundary surface of the second body region, the field junction region including the first conductive type impurity.

The power semiconductor device may include a current spreading layer configured to contact a lower surface of the second body region, the current spreading layer including the first conductive type impurity.

The power semiconductor device includes a drift region, which may be disposed under the current spreading layer and the field junction region, the drift region including the first conductive type impurity.

A first concentration of the first conductive type impurity of the source region may be greater than a second concentration of the first conductive type impurity of the current spreading layer, and the first concentration may be greater than a third concentration of the first conductive type impurity of the drift region.

The power semiconductor device may include a top insulating layer configured to contact an upper surface and a side surface of the planar gate electrode layer and a source electrode layer disposed on the top insulating layer.

The top insulating layer may be configured to contact the bottom insulating layer, the top insulating layer and the bottom insulating layer being disposed on the surface of the semiconductor substrate, and the source electrode layer being configured to contact the source region, the source electrode layer and the source region being disposed on the surface of the semiconductor substrate.

### BRIEF DESCRIPTION OF THE DRAWINGS

FIG. 1 is a perspective view illustrating a portion of a power semiconductor device according to an embodiment of the present disclosure;
FIG. 2 is a cross-sectional view illustrating a surface taken along line A-A' of the power semiconductor device of FIG. 1;
FIG. 3 is a cross-sectional view illustrating a surface taken along line B-B' of a first cross-section of FIG. 2;
FIG. 4 is a cross-sectional view illustrating a surface taken along line C-C' of the first cross-section of FIG. 2;
FIG. 5 is a cross-sectional view illustrating a surface taken along line D-D' of the first cross-section of FIG. 2; and
FIG. 6 is a cross-sectional view illustrating a surface taken along line E-E' of the first cross-section of FIG. 2.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is completely disclosed, and a person with ordinary skill in the art can fully understand the scope of the present disclosure. The present disclosure will be defined only by the scope of the appended claims. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

In a description of the embodiment, in a case in which any one element is described as being formed on or under another element, such a description includes both a case in which the two elements are formed in direct contact with each other and a case in which the two elements are in indirect contact with each other with one or more other elements interposed between the two elements. In addition, when one element is described as being formed on or under another element, such a description may include a case in which the one element is formed at an upper side or a lower side with respect to another element.
The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

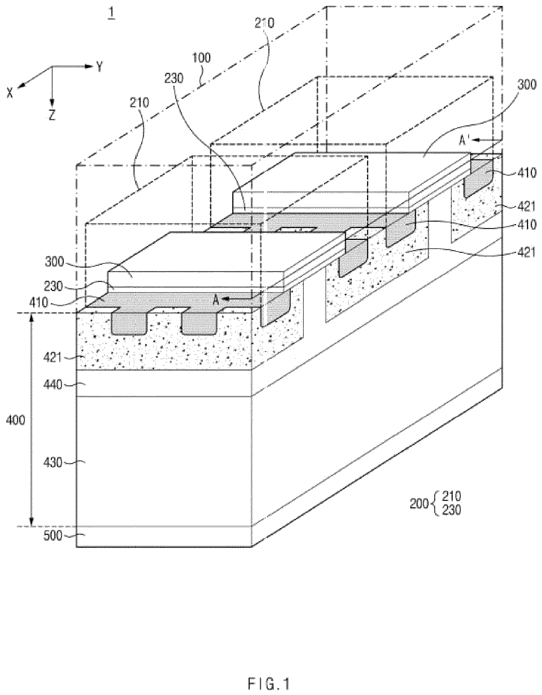

FIG. 1 is a perspective view illustrating a portion of a power semiconductor device 1 according to an embodiment of the present disclosure.

Referring to FIG. 1, the power semiconductor device 1 includes a source electrode layer 100, a top insulating layer 210, a gate electrode layer 300, a semiconductor substrate 400, and a drain electrode layer 500.

The source electrode layer 100 may be disposed on the top insulating layer 210. The source electrode layer 100 may be in contact with the upper surface and the side surface of the top insulating layer 210. The source electrode layer 100 may be a region to which the source voltage is applied. The source electrode layer 100 may include a conductive material, for example, at least one of poly-silicon, poly-silicon including an impurity, a metal, a metal nitride, a metal silicide, or a combination thereof. The source voltage applied to the source electrode layer 100 may be applied to a source region 410.

The top insulating layer 210 may be disposed on the gate electrode layer 300. The top insulating layer 210 may be in contact with the upper surface and side surface of the gate electrode layer 300. The top insulating layer 210 may include an insulating material, for example, at least one of silicon oxide, silicon nitride, germanium oxide, germanium nitride, hafnium oxide, zirconium oxide, aluminum oxide, and a combination thereof. The top insulating layer 210 may electrically separate the source electrode layer 100 from the gate electrode layer 300.

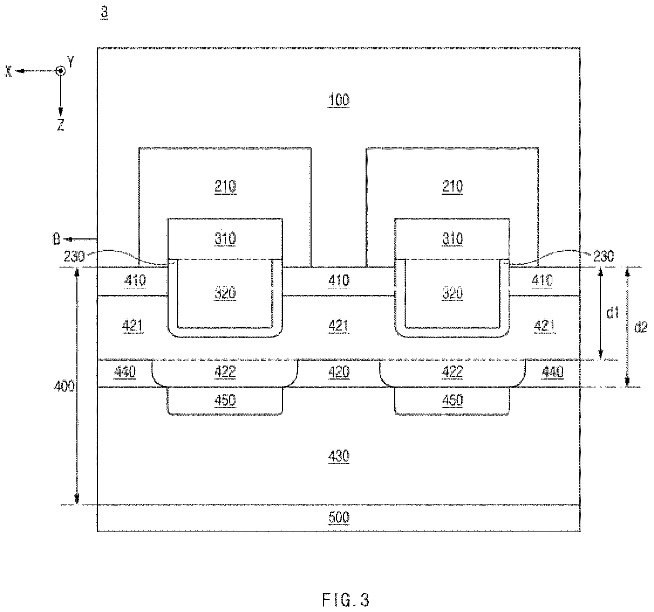

The gate electrode layer 300 may be disposed under the top insulating layer 210. The gate electrode layer 300 may be disposed between the top insulating layer 210 and a bottom insulating layer 230. The gate electrode layer 300 may include a conductive material, for example, at least one of poly-silicon, poly-silicon including an impurity, a metal, a metal nitride, a metal silicide, or a combination thereof. The gate electrode layer 300 includes a planar gate electrode layer (310 of FIG. 3) and a trench gate electrode layer (320 of FIG. 3). A more detailed description of the planar gate electrode layer 310 and the trench gate electrode layer 320 will be made with reference to FIG. 3 below.

The semiconductor substrate 400 includes the source region 410, a first body region 421, a second body region (422 of FIG. 3), a drift region 430, a field junction region 440, and a current spreading layer (450 of FIG. 3). The semiconductor substrate 400 may include a material having a larger band gap (e.g., silicon carbide (SiC), gallium nitride (GaN), etc.) than silicon.

The source region 410 is a region including an impurity of a first conductive type (e.g., an N type). The source region 410 may be a region in contact with the source electrode layer 100 and to which the source voltage is applied by the source electrode layer 100. The source region 410 may be disposed on the upper part of the semiconductor substrate 400. The source region 410 in the first body region 421 and the source electrode layer 100 may be in contact with each other on the surface of the semiconductor substrate 400.

The first body region 421 is a region including an impurity of a second conductive type (e.g., a P type) opposite to the first conductive type. The first body region 421 is in contact with the side surface and lower surface of the source region 410. The first body region 421 is in contact with the side surface of the bottom insulating layer 230. The first body region 421 may form a channel that allows a current to flow between the drift region 430 and the source region 410 when the power semiconductor device 1 is in an on-state. The channel may be formed, for example, in a vertical direction "Z".

The drift region 430 is a region including a first conductive type impurity. The concentration of the first conductive type impurity of the drift region 430 may be lower than the concentration of the first conductive type impurity of the source region 410.

The field junction region 440 may be in contact with the drift region 430. For example, the field junction region 440 may be in contact with the upper surface of the drift region 430. The field junction region 440 may be in contact with the lower surface of the first body region 421. The field junction region 440 may include the first conductive type impurity. The concentration of the first conductive type impurity of the field junction region 440 may be lower than that of the source region 410 and higher than that of the drift region 430.

The description of the second body region (422 of FIG. 3) and the current spreading layer (450 of FIG. 3) will be made with reference to FIG. 3 below.

The drain electrode layer 500 may be disposed under the semiconductor substrate 400. The drain electrode layer 500 may be a region to which a drain voltage (e.g., a ground voltage) is applied. The drain electrode layer 500 may include a conductive material, for example, at least one of poly-silicon, doped poly-silicon, a metal, a metal nitride, a metal silicide, or a combination thereof.

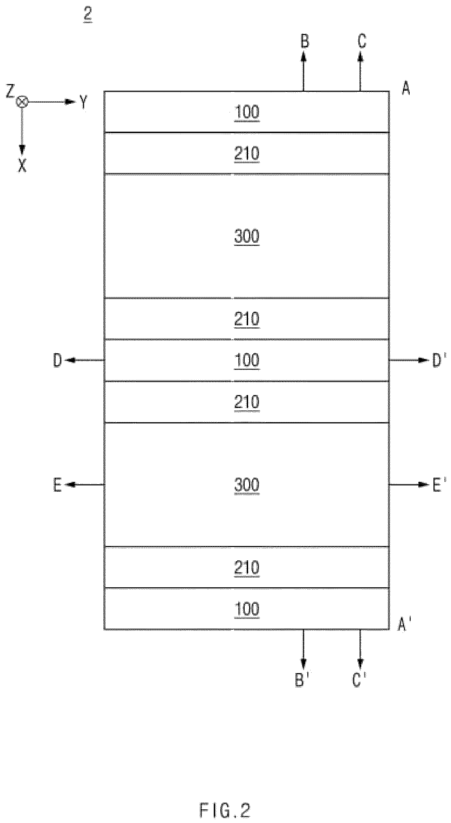

FIG. 2 is a cross-sectional view illustrating a surface taken along line A-A' of the power semiconductor device 1 of FIG. 1.

Referring to FIGS. 1 and 2, a first cross-section 2 may be an embodiment of a cross-section taken along line A-A' of the power semiconductor device 1. The first cross-section 2 may include the source electrode layer 100, the top insulating layer 210, and the gate electrode layer 300.

The source electrode layer 100 may be in contact with the side surface of the top insulating layer 210. For example, the source electrode layer 100 may be disposed between the top insulating layers 210.

The top insulating layer 210 may be in contact with the side surface of the gate electrode layer 300.

The gate electrode layer 300 may be in contact with the top insulating layer 210. For example, the gate electrode layer 300 may be disposed between the top insulating layers 210. The gate electrode layer 300 of the first cross-section 2 may be a part corresponding to the planar gate electrode layer 310 of a second cross-section 3 of FIG. 3.

In FIGS. 3 to 6 below, contents that overlap contents described in FIGS. 1 and 2 will be omitted.

FIG. 3 is a cross-sectional view illustrating a surface taken along line B-B' of the first cross-section 2 of FIG. 2.

Referring to FIGS. 1 to 3, the second cross-section 3 may be an embodiment of a cross-section taken along line B-B' of the first cross-section 2. The second cross-section 3 may include the source electrode layer 100, the top insulating layer 210, the bottom insulating layer 230, the gate electrode layer 300, the semiconductor substrate 400, and the drain electrode layer 500.

The source electrode layer 100 may be disposed on the top insulating layer 210. For example, the source electrode layer 100 may be in contact with the upper surface (surface) of the top insulating layer 210. The source electrode layer 100 may extend in a "Y" direction. The source electrode layer 100 may further extend along a "Z" direction into space between two adjacent top insulating layers 210. For example, the source electrode layer 100 may be in contact with a side surface of the top insulating layer 210. The source electrode layer 100 may be in contact with the upper surface of the semiconductor substrate 400. For example, at least one end of the source electrode layer 100 may be in contact with the upper surface of the semiconductor substrate 400. The source electrode layer 100 may be in contact with the source region 410.

The top insulating layer 210 may be disposed on the gate electrode layer 300. For example, the top insulating layer 210 may be in contact with the upper surface of the planar gate electrode layer 310. The top insulating layer 210 may be in contact with the side surface of the planar gate electrode layer 310. At least one end of the top insulating layer 210 may be in contact with the upper surface of the semiconductor substrate 400. The plurality of top insulating layers 210 may be spaced apart from each other along an "X" direction.

The bottom insulating layer 230 is disposed along the inner wall of a gate trench. The gate trench is recessed into the semiconductor substrate 400 from the upper surface (surface) of the semiconductor substrate 400 along a vertical direction "Z".

The bottom insulating layer 230 may surround a trench structure (e.g., the trench gate electrode layer 320) recessed into the semiconductor substrate 400 among the gate electrode layer 300. The bottom insulating layer 230 is in contact with the lower surface and side surface of the trench gate electrode layer 320 within the semiconductor substrate 400. The bottom insulating layer 230 and the top insulating layer 210 may be in contact with each other on the upper surface of the sem iconductor substrate 400. The bottom insulating layer 230 may electrically separate the trench gate electrode layer 320 from the semiconductor substrate 400.

The top insulating layer 210 and the bottom insulating layer 230 may have a region in contact with each other on the upper surface of the sem iconductor substrate 400. The top insulating layer 210 and the bottom insulating layer 230 may surround the gate electrode layer 300. For example, the top insulating layer 210 and the bottom insulating layer 230 may serve as a gate insulating layer.

The gate electrode layer 300 may be a region to which a gate voltage is applied. When difference between the gate voltage and the source voltage is greater than or equal to the threshold voltage of the power semiconductor device 1, the power semiconductor device 1 may be in an on-state. When the difference between the gate voltage and the source voltage is less than the threshold voltage of the power semiconductor device 1, the power semiconductor device 1 may be in an off-state. When the power semiconductor device 1 is in the on-state, unlike the off-state, a current may flow inside the semiconductor substrate 400 and the power semiconductor device 1 may operate. The gate electrode layer includes the planar gate electrode layer 310 and the trench gate electrode layer 320.

The gate electrode layer 300 may include a conductive material, for example, at least one of poly-silicon, poly-silicon including an impurity, a metal, a metal nitride, a metal silicide, or a combination thereof.

The planar gate electrode layer 310 is in contact with the upper surface of the trench gate electrode layer 320 and may extend in the "Y" direction on the upper surface of the semiconductor substrate 400.

The trench gate electrode layer 320 is disposed inside the gate trench. The trench gate electrode layer 320 may extend in the "X" direction.

The semiconductor substrate 400 includes the source region 410, a body region 420, the drift region 430, the field junction region 440, and the current spreading layer 450. The upper surface of the semiconductor substrate 400 may be the surface of the semiconductor substrate 400 in which the source region 410 is located. The lower surface of the semiconductor substrate 400 may be a surface on which the drain electrode layer 500 and the drift region 430 are in contact with each other.

The source region 410 and the source electrode layer 100 may be in contact with each other on the upper surface of the semiconductor substrate 400. The source region 410 and the top insulating layer 210 may be in contact with each other on the upper surface of the semiconductor substrate 400. For example, the source region 410 may be disposed on each of opposite sides of the planar gate electrode layer 310. The side surface of the source region 410 may be in contact with the bottom insulating layer 230. The source region 410 may be disposed inside the first body region 421.

The first body region 421 may extend from the upper surface of the semiconductor substrate 400 to a first depth d1. The first body region 421 may be disposed between two adjacent bottom insulating layers 230. The first body region 421 may be in contact with the side surface and lower surface of the gate trench and may extend along the "X" direction inside the semiconductor substrate 400. The first body region 421 is in contact with the side surface and lower surface of the bottom insulating layer 230 and may extend in the "X" direction.

The second body region 422 under the gate trench may further extend from the first body region 421 along the "Z" direction. For example, the second body region 422 extends from the upper surface of the semiconductor substrate 400 to a second depth d2. The second depth d2 is larger than the first depth d1. The second body region 422 is a region that is recessed more deeply in the "Z" direction from a portion of the lower surface of the first body region 421.

The second body region 422 overlaps the source region 410 and the bottom insulating layer 230 when viewed in the "Z" direction. The second body region 422 may be in contact with the field junction region 440. A boundary surface on which the second body region 422 and the field junction region 440 are in contact with each other has a downward convex shape. The downward convex shape may mean, for example, a shape that protrudes to the field junction region 440. The boundary surface on which the second body region 422 and the field junction region 440 are in contact with each other overlaps the source region 410 when viewed in the "Z" direction. The boundary surface has a convex shape toward the outside of the second body region 422.

Since the second body region 422 has the convex shape, an electric field concentrated on the boundary surface of the second body region 422 is alleviated, thereby improving the stability of the power semiconductor device 1.

The field junction region 440 may be in contact with the lower surface of the first body region 421 and the side surface (e.g., the boundary surface) of the second body region 422.

The current spreading layer 450 may be disposed under the second body region 422. For example, the current spreading layer 450 may be disposed on the lower surface of the second body region 422. The current spreading layer 450 may include the first conductive type impurity. The concentration of the first conductive type impurity of the current spreading layer 450 may be greater than the concentration of the first conductive type impurity of the drift region 430. The current spreading layer 450 may be disposed on the drift region 430.

The current spreading layer 450 may prevent a tailing phenomenon in which an impurity penetrates much deeper than, for example, the second depth d2 when the second conductive type impurity is injected into the semiconductor substrate 400 to form the body region 420 in the manufacturing process of the power semiconductor device 1.

The drift region 430 is disposed under the second body region 422 and the field junction region 440. The drift region 430 may be disposed under the current spreading layer 450.

The drain electrode layer 500 is disposed under the drift region 430. For example, the drain electrode layer 500 may be in contact with the lower surface of the drift region 430.

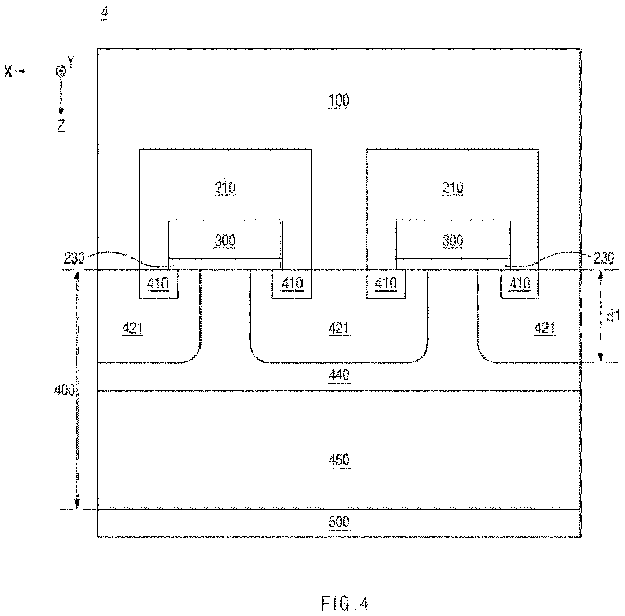

FIG. 4 is a cross-sectional view illustrating a surface taken along line C-C' of the first cross-section 2 of FIG. 2.

In FIG. 4, difference between FIGS. 4 and 3 will be mainly described. Referring to FIGS. 1, 2, and 4, a third cross-section 4 may be an embodiment of a cross-section taken along line C-C' of the first cross-section 2.

The third cross-section 4 includes the source electrode layer 100, the top insulating layer 210, the bottom insulating layer 230, the gate electrode layer 300, the source region 410, the first body region 421, the drift region 430, the field junction region 440, and the drain electrode layer 500.

In the third cross-section 4, the gate electrode layer 300 refers to the planar gate electrode layer 310 of FIG. 3.

The bottom insulating layer 230 may be disposed under the planar gate electrode layer 310. The bottom insulating layer 230 may be disposed on the upper surface of the semiconductor substrate 400.

The source region 410 may be disposed under a region on which the top insulating layer 210 and the upper surface of the semiconductor substrate 400 are in contact with each other. The source region 410 may partially overlap each of the opposite ends of the bottom insulating layer 230 when viewed in the "Z" direction.

Each of the first body regions 421 includes the source region 410 and may be spaced apart from each other along the "X" direction. The first body region 421 may penetrate a portion of the source region 410, and the first body region 421 and the source electrode layer 100 may be in contact with each other on the upper surface of the semiconductor substrate 400. A region between the plurality of first body regions 421 may be filled with the field junction region 440.

The field junction region 440 may be in contact with the side surface and lower surface of the first body region 421. A portion of the field junction region 440 may extend in a direction opposite to the "Z" direction to the upper surface of the semiconductor substrate 400. For example, the field junction region 440 may be in contact with the bottom insulating layer 230.

The drift region 430 may be disposed under the field junction region 440.

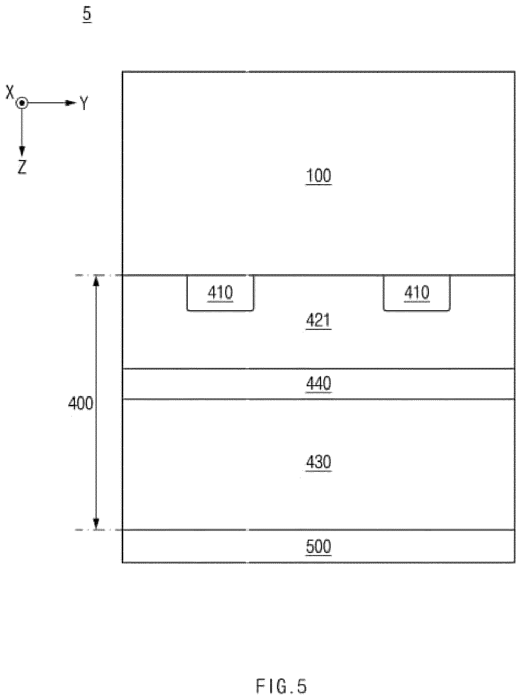

FIG. 5 is a cross-sectional view illustrating a surface taken along line D-D' of the first cross-section 2 of FIG. 2.

In FIG. 5, difference between FIGS. 5, 3, and 4 will be mainly described. Referring to FIGS. 1, 2, and 5, a fourth cross-section 5 may be an embodiment of a cross-section taken along line D-D' of the first cross-section 2. The fourth cross-section 5 includes the source electrode layer 100, the semiconductor substrate 400, and the drain electrode layer 500.

The semiconductor substrate 400 includes the source region 410, the first body region 421, the drift region 430, and the field junction region 440.

The source electrode layer 100 and each of the source region 410 and the first body region 421 may be in contact with each other on the upper surface of the semiconductor substrate 400. A region on which the source electrode layer 100 and the source region 410 are in contact with each other and a region on which the source electrode layer 100 and the first body region 421 are in contact with each other may alternate along the "Y" direction.

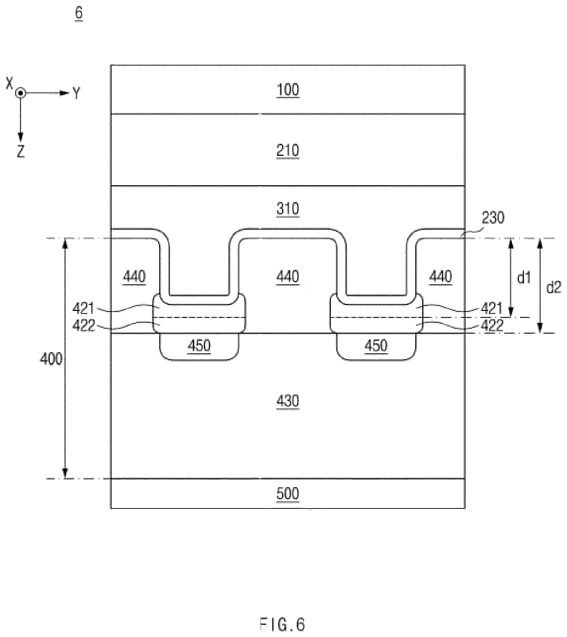

FIG. 6 is a cross-sectional view illustrating a surface taken along line E-E' of the first cross-section 2 of FIG. 2.

In FIG. 6, difference between FIGS. 6 and 5 will be mainly described. Referring to FIGS. 1, 2, 5, and 6, a fifth cross-section 6 includes the source electrode layer 100, the top insulating layer 210, the bottom insulating layer 230, the gate electrode layer 300, the semiconductor substrate 400, and the drain electrode layer 500.

The gate electrode layer 300 includes the planar gate electrode layer 310 and the trench gate electrode layer 320.

The trench gate electrode layers 320 are recessed into the semiconductor substrate 400, extend in the "X" direction, and be spaced apart from each other in the "Y" direction.

The planar gate electrode layer 310 may be in contact with each of the upper surfaces of the plurality of trench gate electrode layers 320 and may extend in the "Y" direction on the surface of the semiconductor substrate 400.

The bottom insulating layer 230 is in contact with the lower surface of the planar gate electrode layer 310 and is disposed on the surface of the semiconductor substrate 400. The bottom insulating layer 230 surrounds the lower surface and side surface of the trench gate electrode layer 320.

The semiconductor substrate 400 includes the first body region 421, the second body region 422, the drift region 430, the field junction region 440, and the current spreading layer 450.

Each of the first body region 421 and the second body region 422 may, for example, have the same concentration of the first conductive type impurity but may have different concentration thereof due to process variables or limitations.

The first body region 421 and the second body region 422 are disposed under the trench gate electrode layer 320. The first body region 421 and the second body region 422 alleviate electric field concentration in portions surrounding the side surface and lower surface of the trench gate electrode layer 320 among the bottom insulating layer 230, thereby preventing insulation breakdown of the bottom insulating layer 230 and increasing the stability of the power semiconductor device 1.

The second body region 422 is disposed under the first body region 421, and the current spreading layer 450 may be disposed under the second body region 422.

The field junction region 440 may be in contact with the surface of the semiconductor substrate 400 and may extend, for example, to the second depth d2.

The drift region 430 may be in contact with the lower surface of the field junction region 440 and may be in contact with, for example, the side surface and lower surface of the current spreading layer 450.

Various embodiments of the present disclosure do not list all available combinations but are for describing a representative aspect of the present disclosure, and descriptions of various embodiments may be applied independently or may be applied through a combination of two or more.

A number of embodiments have been described above. Nevertheless, it will be understood that various modifications may be made. Accordingly, other implementations are within the scope of the following claims.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Therefore, the scope of the disclosure is defined not by the detailed description, but by the claims, and all variations within the scope of the claims are to be construed as being included in the disclosure.

## Claims

1. A power semiconductor device, comprising:
first and second trench gate electrode layers (320) in respective trenches recessed into a semiconductor substrate (400), the first and second trench gate electrode layers (320) being configured to extend in a first direction and configured to be spaced apart from each other in a second direction;
a planar gate electrode layer (310) configured to contact an upper surface of each of the first and second trench gate electrode layers (320) and to extend in the second direction on a surface of the semiconductor substrate (400);
a bottom insulating layer (230) configured to surround a lower surface and a side surface of each of the trench gate electrode layer (320);
a body region comprising:
a first body region (421) configured to contact a side surface and a lower surface of the bottom insulating layer (230) and to extend in the second direction; and
a second body region (422) provided at a second depth being greater than a first depth of the first body region (421) from a first portion of a lower surface of the first body region (421);
a drift region (430) disposed under the second body region (422) and a drain electrode layer (500) disposed under the drift region (430); and
a source region (410) provided inside the first body region (421) and configured to contact the surface of the semiconductor substrate (400) and the side surfaces of the trenches,
wherein the source region (410) and the drift region (430) comprisesa first conductive type impurity,
wherein the body region comprises a second conductive type impurity, and
wherein the second body region (422) is configured to laterally overlap the source region (410) and the bottom insulating layer (230) and defining an outwardly convex boundary surface in a second portion overlapping the source region (410).

2. The power semiconductor device of claim 1, further comprising:
a field junction region configured to contact the lower surface of the first body region (421) and the outwardly convex boundary surface of the second body region (422), the field junction region comprising the first conductive type impurity.

3. The power semiconductor device of claim 2, further comprising:
a current spreading layer (450) configured to contact a lower surface of the second body region (422), the current spreading layer (450) comprising the first conductive type impurity.

4. The power semiconductor device of claim 3, wherein the drift region (430) is disposed under the current spreading layer (450) and the field junction region.

5. The power semiconductor device of claim 4, wherein a first concentration of the first conductive type impurity of the source region (410) is greater than a second concentration of the first conductive type impurity of the current spreading layer (450), and
wherein the first concentration is greater than a third concentration of the first conductive type impurity of the drift region (430).

6. The power semiconductor device of claim 1, further comprising:
a top insulating layer (210) configured to contact an upper surface and a side surface of the planar gate electrode layer (310); and
a source electrode layer (100) disposed on the top insulating layer (210).

7. The power semiconductor device of claim 6, wherein the top insulating layer (210) is configured to contact the bottom insulating layer (230), the top insulating layer (210) and the bottom insulating layer (230) being disposed on the surface of the semiconductor substrate (400), and
wherein the source electrode layer (100) is configured to contact the source region (410) , the source electrode layer (100) and the source region (410) being disposed on the surface of the semiconductor substrate (400).

## Patentansprüche

1. Leistungshalbleiterbauelement, aufweisend:
eine erste und eine zweite Graben-Gate-Elektrodenschicht (320) in jeweiligen Gräben, die in ein Halbleitersubstrat (400) eingelassen sind, wobei die erste und die zweite Graben-Gate-Elektrodenschicht (320) konfiguriert sind, um sich in einer ersten Richtung zu erstrecken, und konfiguriert sind, um in einer zweiten Richtung voneinander beabstandet zu sein;
eine planare Gate-Elektrodenschicht (310), die konfiguriert ist, um eine oberste Oberfläche jeder der ersten und der zweiten Graben-Gate-Elektrodenschicht (320) zu kontaktieren und um sich in der zweiten Richtung auf einer Oberfläche des Halbleitersubstrats (400) zu erstrecken;
eine untere Isolierschicht (230), die konfiguriert ist, um eine niedrigere Oberfläche und eine Seitenoberfläche jeder der Graben-Gate-Elektrodenschicht (320) zu umgeben;
einen Körperbereich, aufweisend:
einen ersten Körperbereich (421), der konfiguriert ist, um eine Seitenoberfläche und eine niedrigere Oberfläche der unteren Isolierschicht (230) zu kontaktieren und sich in der zweiten Richtung zu erstrecken; und
einen zweiten Körperbereich (422), der in einer zweiten Tiefe bereitgestellt ist, die größer als eine erste Tiefe des ersten Körperbereichs (421) von einem ersten Abschnitt einer niedrigeren Oberfläche des ersten Körperbereichs (421) ist;
einen Driftbereich (430), der unter dem zweiten Körperbereich (422) angeordnet ist, und eine Drain-Elektroden-Schicht (500), die unter dem Driftbereich (430) angeordnet ist; und
einen Source-Bereich (410), der innerhalb des ersten Körperbereichs (421) bereitgestellt und konfiguriert ist, um die Oberfläche des Halbleitersubstrats (400) und die Seitenoberflächen der Gräben zu kontaktieren,
wobei der Source-Bereich (410) und der Drift-Bereich (430) eine Störstelle einer ersten leitfähigen Art aufweisen,
wobei der Körperbereich eine Störstelle einer zweiten leitfähigen Art aufweist und
wobei der zweite Körperbereich (422) konfiguriert ist, um den Source-Bereich (410) und die untere Isolierschicht (230) lateral zu überlappen, und eine nach außen konvexe Grenzoberfläche in einem zweiten Abschnitt definiert, der den Source-Bereich (410) überlappt.

2. Leistungshalbleiterbauelement nach Anspruch 1, ferner aufweisend:
einen Feldübergangsbereich, der konfiguriert ist, um die niedrigere Oberfläche des ersten Körperbereichs (421) und die nach außen konvexe Grenzoberfläche des zweiten Körperbereichs (422) zu kontaktieren, wobei der Feldübergangsbereich die Störstelle der ersten leitfähigen Art aufweist.

3. Leistungshalbleiterbauelement nach Anspruch 2, ferner aufweisend:
eine Stromausbreitungsschicht (450), die konfiguriert ist, um eine niedrigere Oberfläche des zweiten Körperbereichs (422) zu kontaktieren,wobei die Stromausbreitungsschicht (450) die Störstelle der ersten leitfähigen Art aufweist.

4. Leistungshalbleiterbauelement nach Anspruch 3, wobei der Driftbereich (430) unter der Stromausbreitungsschicht (450) und dem Feldübergangsbereich angeordnet ist.

5. Leistungshalbleiterbauelement nach Anspruch 4, wobei eine erste Konzentration der Störstelle der ersten leitfähigen Art des Source-Bereichs (410) größer als eine zweite Konzentration der Störstelle der ersten leitfähigen Art der Stromausbreitungsschicht (450) ist und
wobei die erste Konzentration größer als eine dritte Konzentration der Störstelle der ersten leitfähigen Art des Driftbereichs (430) ist.

6. Leistungshalbleiterbauelement nach Anspruch 1, ferner aufweisend:
eine obere Isolierschicht (210), die konfiguriert ist, um eine oberste Oberfläche und eine Seitenoberfläche der planaren Gate-Elektrodenschicht (310) zu kontaktieren; und
eine Source-Elektrodenschicht (100), die auf der oberen Isolierschicht (210) angeordnet ist.

7. Leistungshalbleiterbauelement nach Anspruch 6, wobei die obere Isolierschicht (210) konfiguriert ist, um die untere Isolierschicht (230) zu kontaktieren, wobei die obere Isolierschicht (210) und die untere Isolierschicht (230) auf der Oberfläche des Halbleitersubstrats (400) angeordnet sind und
wobei die Source-Elektrodenschicht (100) konfiguriert ist, um den Source-Bereich (410) zu kontaktieren, wobei die Source-Elektrodenschicht (100) und der Source-Bereich (410) auf der Oberfläche des Halbleitersubstrats (400) angeordnet sind.

## Revendications

1. Dispositif à semi-conducteurs de puissance, comprenant :
des première et seconde couches d'électrode de grille de tranchée (320) dans des tranchées respectives encastrées dans un substrat semi-conducteur (400), les première et seconde couches d'électrode de grille de tranchée (320) étant conçues pour s'étendre dans une première direction et conçues pour être espacées l'une de l'autre dans une seconde direction ;
une couche d'électrode de grille plane (310) conçue pour entrer en contact avec une surface supérieure de chacune des première et seconde couches d'électrode de grille de tranchée (320) et pour s'étendre dans la seconde direction sur une surface du substrat semi-conducteur (400) ;
une couche isolante inférieure (230) conçue pour entourer une surface inférieure et une surface latérale de chacune des couches d'électrode de grille de tranchée (320) ;
une région de corps comprenant :
une première région de corps (421) conçue pour entrer en contact avec une surface latérale et une surface inférieure de la couche isolante inférieure (230) et pour s'étendre dans la seconde direction ; et
une seconde région de corps (422) prévue à une seconde profondeur supérieure à une première profondeur de la première région de corps (421) à partir d'une première partie d'une surface inférieure de la première région de corps (421) ;
une région de dérive (430) disposée sous la seconde région de corps (422) et une couche d'électrode de drain (500) disposée sous la région de dérive (430) ; et
une région de source (410) prévue à l'intérieur de la première région de corps (421) et conçue pour entrer en contact avec la surface du substrat semi-conducteur (400) et les surfaces latérales des tranchées,
dans lequel la région de source (410) et la région de dérive (430) comprennent une impureté à premier type de conductivité,
dans lequel la région de corps comprend une impureté à second type de conductivité, et
dans lequel la seconde région de corps (422) est conçue pour chevaucher latéralement la région de source (410) et la couche isolante inférieure (230) et définissant une surface limite convexe vers l'extérieur dans une seconde partie chevauchant la région de source (410).

2. Dispositif à semi-conducteurs de puissance selon la revendication 1, comprenant en outre :
une région de jonction de champ conçue pour entrer en contact avec la surface inférieure de la première région de corps (421) et la surface limite convexe vers l'extérieur de la seconde région de corps (422), la région de jonction de champ comprenant l'impureté à premier type de conductivité.

3. Dispositif à semi-conducteurs de puissance selon la revendication 2, comprenant en outre :
une couche d'étalement de courant (450) conçue pour entrer en contact avec une surface inférieure de la seconde région de corps (422), la couche d'étalement de courant (450) comprenant l'impureté à premier type de conductivité.

4. Dispositif à semi-conducteurs de puissance selon la revendication 3, dans lequel la région de dérive (430) est disposée sous la couche d'étalement de courant (450) et la région de jonction de champ.

5. Dispositif à semi-conducteurs de puissance selon la revendication 4, dans lequel une première concentration de l'impureté à premier type de conductivité de la région de source (410) est supérieure à une deuxième concentration de l'impureté à premier type de conductivité de la couche d'étalement de courant (450), et
dans lequel la première concentration est supérieure à une troisième concentration de l'impureté à premier type de conductivité de la région de dérive (430).

6. Dispositif à semi-conducteurs de puissance selon la revendication 1, comprenant en outre :
une couche isolante supérieure (210) conçue pour entrer en contact avec une surface supérieure et une surface latérale de la couche d'électrode de grille plane (310) ; et
une couche d'électrode source (100) disposée sur la couche isolante supérieure (210).

7. Dispositif à semi-conducteurs de puissance selon la revendication 6, dans lequel la couche isolante supérieure (210) est conçue pour entrer en contact avec la couche isolante inférieure (230), la couche isolante supérieure (210) et la couche isolante inférieure (230) étant disposées sur la surface du substrat semi-conducteur (400), et
dans lequel la couche d'électrode source (100) est conçue pour entrer en contact avec la région de source (410), la couche d'électrode source (100) et la région de source (410) étant disposées sur la surface du substrat semi-conducteur (400).
